# EUROPÄISCHE PATENTSCHRIFT

(11) **EP 3 095 307 B1**
(45) Veröffentlichungstag und Bekanntmachung des Hinweises auf die Patenterteilung: **28.11.2018**
(21) Anmeldenummer: 14783877.5
(22) Anmeldetag: 14.10.2014
(51) Int. Cl.: H05K 1/02, H05K 1/05, H01L 23/367, H05K 1/11, H05K 1/14

(54) **LEITERPLATTE, SCHALTUNG UND VERFAHREN ZUR HERSTELLUNG EINER SCHALTUNG**
PRINTED CIRCUIT BOARD, CIRCUIT, AND METHOD FOR THE PRODUCTION OF A CIRCUIT
CIRCUIT IMPRIMÉ, MONTAGE ET PROCÉDÉ DE FABRICATION D'UN MONTAGE

(30) Priorität: 13.01.2014 DE 102014000126
(43) Veröffentlichungstag der Anmeldung: 23.11.2016
(73) Patentinhaber: Auto-Kabel Management GmbH, 79688 Hausen i.W. (DE)
(72) Erfinder: TAZARINE, Wacim, 41239 Mönchengladbach (DE); BETSCHER, Simon, 41515 Grevenbroich (DE); GRONWALD, Frank, 50181 Bedburg (DE)
(74) Vertreter: Cohausz & Florack
(86) Internationale Anmeldenummer: PCT/EP2014/071994
(87) Internationale Veröffentlichungsnummer: WO 2015/104072

(56) Entgegenhaltungen:
- EP-A2- 1 261 028
- DE-A1-102004 043 276
- US-A1- 2008 186 623
- US-A1- 2010 012 360

## Beschreibung

Der Gegenstand betrifft Leiterplatten sowie eine Schaltung und ein Verfahren zur Herstellung von Schaltungen, insbesondere für Leistungshalbleiter, insbesondere für SMD (Surface Mounted Devices) Bauelemente.

In der Halbleitertechnologie sind Leiterplatten in der Regel aus Isolationsmaterial als Träger und einer leitenden Schicht, aus der Leiterbahnen durch Ätzen geformt werden, gebildet. Im Bereich der Leistungshalbleiter ist es jedoch auch möglich, die Leiterplatten zusätzlich mit einem metallischen Kern, beispielsweise einem kupfernen Kern vorzusehen. Dieser Kupferkern ist beidseitig mit dem Isolationsmaterial, einem sogenannten Prepreg beschichtet und somit allseitig isoliert. Auch hierbei wird eine auf eine Oberfläche des Isolationsmaterials aufgepresste Kupferfolie als leitende Schicht genutzt und auf dieser Kupferfolie werden ebenfalls Leiterbahnen geformt. Die aus der Kupferfolie gebildeten Leiterbahnen werden teilweise unmittelbar mit dem metallischen Kern kontaktiert, indem sogenannte µVias sowohl mit der Leiterbahn als auch dem Kupferkern durch das Prepreg hindurch kontaktiert werden. Der andere Teil der Leiterbahnen sind Signalleitungen auf der Oberfläche der Leiterplatte. Das Aufbringen der sogenannten µVias ist jedoch kompliziert und aufwendig, da es beispielsweise notwendig ist, das Prepreg nach dem Aufbringen der Kupferfolie zu fräsen und ein metallisches Material darin einzubringen. Anschließend sind die Leiterbahnen zu ätzen. Die µVias weisen nur geringe Leitungsdurchmesser auf, sodass sowohl der elektrische als auch der thermische Übergangswiderstand hoch und die Kühlwirkung begrenzt ist. Auch ist das Fräsen der Vias kompliziert, da nur sehr kleine Durchgänge gefräst oder gebohrt werden können.

Eine weitere Technologie, die insbesondere im Bereich der LEDs verwendet wird, ist die Verwendung eines Kupfer- bzw. Aluminiumträgerplatte ausschließlich zur Kühlung. Die Kupfer- bzw. Aluminiumträgerplatte ist vollständig gegenüber den Leiterbahnen durch ein Isolationsmaterial, beispielsweise das Prepreg, isoliert. Zwischen der Kupfer- bzw. Aluminiumträgerplatte und den Leiterbahnen sind keinerlei elektrisch leitende Verbindungen vorhanden. Thermische Energie wird durch das Prepreg hindurch zu der Kupfer- bzw. Aluminiumträgerplatte geleitet. Somit können mit den Leiterbahnen verbundene elektrische Komponenten über die Kupfer- bzw. Aluminiumträgerplatte gekühlt werden. Die Kühlwirkung ist jedoch durch das Prepreg behindert und eine elektrische Kontaktierung über die Kupfer- bzw. Aluminiumträgerplatte ist bei dieser Technologie weder möglich noch erwünscht. Zusätzlich kann unterhalb der Kupfer- bzw. Aluminiumträgerplatte mit Wärmeleitpaste ein Kühlkörper angebracht werden.

Die genannten Technologien sind für Hochleistungshalbleiter im Bereich der automotiven Anwendung entweder zu teuer oder verfügen über keine ausreichende Kühlung. Somit lag dem Gegenstand die Aufgabe zu Grunde, Leiterplatten zur Verfügung zu stellen, die einerseits einfach und kostengünstig herstellbar sind und auf der anderen Seite eine ausreichende Kühlung für Leistungshalbleiter ermöglichen.

Die US 2008/186623 A1 beschreibt ein flexibles Kabel, welches aus einem Träger, einem Isolator und Leiterbahn gebildet ist.

Diese Aufgabe wird durch eine Leiterplatte nach Anspruch 1, eine Schaltung nach Anspruch 5 sowie ein Verfahren nach Anspruch 15 gelöst.

Es ist erkannt worden, dass die Kühlwirkung einer Kupferplatte verstärkt werden kann, wenn diese unmittelbar mit einem Kontakt für den Halbleiter versehen ist. Es wird vorgeschlagen, eine metallische Trägerplatte zu verwenden. Diese metallische Trägerplatte kann aus Kupfer sein. Auch Legierungen hiervon sind möglich. Darüber hinaus ist es auch möglich, dass die metallische Trägerplatte, beispielsweise um Gewicht einzusparen, aus Aluminium gebildet ist und auf der Oberfläche metallisch beschichtet ist, insbesondere mit Kupfer oder einer Kupferlegierung.

Auf die Trägerplatte wird eine Isolationsschicht, insbesondere ein Isolationslack, aufgebracht, die die Trägerplatte elektrisch isoliert. In einem Anschlussbereich ist die Trägerplatte jedoch frei von der Isolationsschicht.

Um nun einen an der Leiterplatte angebrachten Halbleiter, insbesondere einem Leistungs- bzw. Hochleistungshalbleiter unmittelbar mit der Trägerplatte elektrisch als auch thermisch zu kontaktieren, wird vorgeschlagen, dass die Trägerplatte im Anschlussbereich metallisch beschichtet ist. Die metallische Beschichtung kann vor dem Aufbringen der Isolationsschicht oder nach dem Aufbringen der Isolationsschicht geformt werden.

Der Halbleiter ist vorzugsweise ein Transistor, vorzugsweise ein Leistungstransistor. Insbesondere kann der Halbleiter ein Hochleistungshalbleiter mit einer Stromtragfähigkeit von über 10 Ampere, vorzugsweise über 50A, insbesondere mehr als 300A sein. Insbesondere können Transistoren, Thyristoren, Triacs oder dergleichen zum Einsatz kommen. Auch können IGB Transistoren und Leistungs-MOSFETS zum Einsatz kommen.

Die gegenständliche Verwendung der Schaltung ist bevorzugt im Bereich einen Gleichrichters, insbesondere im Bereich eines Batteriemanagements eines Fahrzeugs. Insbesondere ist die Verwendung als Gleichrichter in einem Elektrofahrzeug oder einem Hybridfahrzeug bevorzugt. Vorzugsweise wird eine Verwendung in Anwendungen vorgeschlagen, die mit Strömen von mehr als 10 A, vorzugsweise mehr als 50 A oder mehr als 300 A arbeiten.

Die metallische Beschichtung wird unmittelbar auf die Trägerplatte aufgebracht und dient anschließend als Kontakt für den Halbleiter. Auf der metallischen Beschichtung des Anschlussbereichs ist ein Kontakt des Halbleiters elektrisch kontaktiert. Die Trägerplatte dient somit als thermisches und elektrisches Element. Dadurch, dass die metallische Beschichtung unmittelbar für den Kontakt des Halbleiters mit der Trägerplatte dient, ist ein sehr guter thermischer Kontakt zwischen dem Halbleiter und der Trägerplatte gewährleistet. Die Trägerplatte dient unmittelbar als Zuleitung für einen Kontakt des Halbleiters und kann von einem Bereich außerhalb der Isolationsschicht elektrisch kontaktiert werden.

Die Trägerplatte kann ein Flachteil sein, insbesondere ein Band oder Blech.

Der Kontakt des Halbleiters ist vorzugsweise ein Drain- oder Source-Kontakt, wobei diese Bezeichnung hier stellvertretend für die die Leistung führenden Kontakte des Halbleiters ist. Gate oder Schaltkontakte des Halbleiters führen in der Regel nur Schaltströme und der geschaltete Strom fließt über die zumindest zwei anderen Kontakte. Der Halbleiter ist vorzugsweise ein SMD-Bauteil, welches unmittelbar auf der metallischen Beschichtung des Anschlussbereichs aufliegt. Nichtleitende Bereiche des Halbleiters können auf der Isolationsschicht aufliegen.

Die Isolationsschicht ist vorzugsweise ein Lötstopplack, der beispielsweise derart aufgebracht wird, dass der Anschlussbereich frei von der Isolationsschicht ist. Anschließend kann mittels Verzinnen der Anschlussbereich metallisch beschichtet werden.

Vorzugsweise wird die Isolationsschicht vor der metallischen Beschichtung auf die Trägerplatte aufgedruckt.

Gemäß einem Ausführungsbeispiel ist die metallische Beschichtung eine Zinnschicht. Die Zinnschicht ist vorzugsweise großflächig, beispielsweise auf jeweils einer Anschlussfläche zwischen 5 cm² und 0,5 mm² auf der Trägerplatte aufgebracht.

Um den Halbleiter mechanisch zu stützen und die elektrische Kontaktierung möglichst frei von mechanischen Spannungen zu halten, wird vorgeschlagen, dass die metallische Beschichtung im Wesentlichen planparallel zur Oberfläche der Isolationsschicht ist. In diesem Fall können nichtleitende Bereiche, die den Kontakt des Halbleiters umgeben, unmittelbar auf der Isolationsschicht aufliegen. Der Halbleiter verfügt in der Regel über einen großflächigen Drain- oder Source-Kontakt. Vorzugsweise ist der Anschlussbereiche beziehungsweise die metallische Beschichtung in ihrer Fläche im Wesentlichen kongruent zu der Fläche des Kontakts des Halbleiters.

Während der Herstellung kann der Halbleiter dann unmittelbar auf dem Anschlussbereich aufgesetzt werden. Nichtleitende Bereiche, insbesondere in Randbereichen des Halbleiters, können auf der Isolationsschicht aufliegen und die Befestigung des Halbleiters ist somit besonders einfach. Auch ergibt sich eine große Kontaktfläche zwischen dem Kontakt des Halbleiters und der metallischen Beschichtung, sodass neben einem guten elektrischen Kontakt auch eine hervorragende Wärmeleitung von dem Kontakt des Halbleiters in die Trägerplatte ermöglicht ist.

Wie bereits erwähnt, ist der Halbleiter beziehungsweise der Kontakt des Halbleiters elektrisch mit der Trägerplatte durch die metallische Beschichtung kontaktiert. Die Trägerplatte kann an einem freien Ende ein Anschluss für eine Kontaktierung mit einer elektrischen Schaltung aufweisen. Hier ist es beispielsweise möglich, dass eine Bohrung zur Aufnahme einer Anschlussfahne vorhanden ist. Auch kann ein Kabelschuh oder ein Crimpanschluss am Ende der Trägerplatte vorgesehen sein, und so kann die Leiterplatte besonders einfach elektrisch kontaktiert werden.

Insbesondere ist dabei darauf zu achten, dass eine hohe Stromtragfähigkeit ermöglicht ist. Eine Kontaktierung mit einer elektrischen Schaltung erfolgt daher vorzugsweise mit einer Leitung mit einem Leitungsquerschnitt von zumindest 2,5 mm², sodass die Kontaktierung am Ende der Trägerplatte eine solch große Kontaktfläche aufweisen muss. Auch der Leitungsquerschnitt der Trägerplatte ist zumindest entsprechend dem Leitungsquerschnitt zu wählen, vorzugsweise jedoch größer als der Leitungsquerschnitt der angeschlossenen Leitung.

Bevorzugt sind entlang einer gemeinsamen Außenkante, insbesondere einer Längskante der Trägerplatte zwei oder mehr Anschlussbereiche nebeneinander, getrennt durch die Isolationsschicht angeordnet. Insbesondere können mehr als zwei einander zugeordnete Anschlussbereiche an einer Außenkante der Trägerplatte angeordnet sein. Auch können die Anschlussbereiche an zwei distalen Außenkanten der Trägerplatte angeordnet sein.

Gemäß einem weiteren Aspekt wird eine Leiterplatte vorgeschlagen, die ebenfalls eine metallische Trägerplatte aufweist. Die metallische Trägerplatte kann zu der metallischen Trägerplatte der Leiterplatte nach Anspruch 1 gleich sein. Insbesondere können gleiche Materialien, gleiche Leiterquerschnitte und/oder gleiche Formfaktoren verwendet werden. Dies macht die Massenproduktion der Leiterplatten günstig.

Die metallische Trägerplatte ist ebenfalls auf mindestens einer Oberfläche elektrisch isolierend beschichtet. Der dabei verwendete Isolator kann zunächst vollflächig auf der Oberfläche der Trägerplatte aufgebracht sein. Insbesondere kann ein herkömmlich als Träger für Leiterplatten eingesetzter Isolator verwendet werden. Dies kann eine Kunststoffplatte sein. Insbesondere kann eine aus *preimpregnated fibres,* zu Deutsch: "vorimprägnierte Fasern" sogenannte Prepreg Schicht als Isolator verwendet werden. Anschließend wird auf den Isolator eine Leitschicht aufgebracht. Der Isolator und die Leitschicht können vollflächig mit der Trägerplatte verpresst sein. Die Leitschicht kann beispielsweise eine Kupferschicht sein.

Aus der Leitschicht können in bekannter Weise Leiterbahnen geätzt werden, wie das bei der Herstellung von herkömmlichen Leiterplatten üblich ist.

Außerdem kann auf den Isolator und die Leitschicht eine Isolationsschicht, insbesondere eine Isolationsbeschichtung, wie bei der Leiterplatte nach Anspruch 1 aufgebracht sein. Dies kann ebenfalls ein Isolationslack, insbesondere ein Lötstoplack sein. Dieser kann vor oder nach dem Formen der Leiterbahnen erfolgen.

Mittels Fräsen oder Bohren können Isolator sowie Leitschicht, falls noch nicht weggeätzt, durchbrochen werden, um einen Kontaktbereich zu der Trägerplatte zu bilden. Hierbei können fensterartige Durchbrechungen des Isolators den Kontaktbereich bilden. In dem Kontaktbereich kann die Trägerplatte zunächst freigelegt sein, um dann hierauf zumindest ein Kontaktpad zu bilden.

Um nun eine Kontaktierung eines Halbleiters zu ermöglichen, wird vorgeschlagen, dass in dem Kontaktbereich zumindest ein metallisches Kontaktpad auf der Trägerplatte angeordnet ist. Dabei ist das Kontaktpad umlaufend beabstandet von dem Isolator und der Leitschicht ist. Hierbei kann das Kontaktpad zumindest aus der Ebene des Isolators herausragen. Wenn auf dem Isolator noch zusätzlich eine Isolationsschicht, z.B. ein Isolationslack gebildet ist, kann das Kontaktpad im Wesentlichen in der Ebene der Isolationsschicht enden.

Um zu vermeiden, dass ein elektrischer Kontakt zwischen dem Kontaktpad und der Leitschicht entsteht, ist das Kontaktpad vollständig umlaufend beabstandet von der der Leitschicht. Somit ist anders als bei herkömmlichen µVias das Kontaktpad nicht dazu geeignet, die Leiterbahn der Leitschicht mit der Trägerplatte zu verbinden, um eine Kühlung von der Leiterbahn der Leitschicht zu ermöglichen. Vielmehr wird die Trägerplatte als elektrisch leitendes Element unmittelbar mit dem Kontaktpad kontaktiert und auf dem Kontaktpad kann ein elektrischer Kontakt, insbesondere ein Source- oder Drain-Kontakt eines Halbleiters aufgebracht werden. Auch ist die Kontaktfläche im Gegensatz zu den µVias als fensterartige Durchbrechung des Isolators geformt, so dass deren Herstellung einfach ist. Die Kontaktfläche ist in der Regel 2 bis 10, vorzugsweise 4 bis 7 mal so groß wie die Fläche eines einzelnen Kontaktpads.

Insbesondere, wenn der Halbleiter ein SMD-Bauelement ist, und Source bzw. Drain zusammen mit Gate entlang einer Kante des Halbleiters über Kontaktpins, welche auf einer Ebene liegen, kontaktiert werden sollen, ist es vorteilhaft, wenn die Kontaktpads im Wesentlichen planparallel zu der Leitschicht sind. In diesem Fall kann der Halbleiter auf das Kontaktpad und gleichzeitig die Leitschicht aufgelegt werden. Ein Verwinkeln oder Verkanten relativ zur Leitschicht beziehungsweise dem Kontaktpad ist dann erschwert. Auf der Leitschicht beziehungsweise der Leiterbahn der Leitschicht kann ein Gate-Kontaktpin kontaktiert werden und das Kontaktpad kann mit dem Drain- oder Source-Kontaktpin kontaktiert werden.

Insbesondere können mehrere nebeneinander angeordnete Kontaktpads gebildet sein, welche jeweils eine Auflagefläche entsprechend einem Kontaktpin des Halbleiters haben. An dem Halbleiter sind entlang einer gemeinsamen Kante mehrere Drain- oder Source-Kontaktpins und ein Gate-Kontaktpin angeordnet. An einer distalen Kante ist der entsprechende Source- oder Drain Kontakt vorgesehen. Die mehreren Source- oder Drain-Kontaktpins, die auf der Seite des Gate-Kontaktpins angeordnet sind, können auf das Kontaktpad beziehungsweise die Kontaktpads die nebeneinander angeordnet sind aufgelegt werden und der Gate-Kontaktpin kann auf die Leitschicht aufgelegt werden. Anschließend kann eine besonders einfache Kontaktierung durch SMD-Löten erfolgen.

Um das Kontaktpad auf der Trägerplatte zu erstellen, kann der Kontaktbereich mit einem Fotoresist beschichtet werden und dann im Bereich der Kontaktpads, beabstandet von dem Isolator belichtet werden. Nach dem Entfernen des belichteten Bereichs des Fotoresists liegt dort die Trägerplatte frei. Auf diesen Bereich kann dann vorzugsweise chemisch das Kontaktpad aufgebaut werden. Die nicht belichteten Bereiche des Fotoresists bzw. der Trägerplatte werden dabei nicht mit Kupfer beaufschlagt. Das erstellte Kontaktpad ist somit beabstandet von dem Isolator als auch der Leitschicht.

Das Kontaktpad hat eine lötbare Metalloberfläche. Diese kann wie erwähnt chemisch aufgebaut werden, beispielsweise durch Aufbringen von Nickel oder Zinn. Auch kann galvanisch Nickel oder Gold aufgebracht werden. Ein chemisches Aufbringen von Zinn oder Silber im Bereich des belichteten Bereichs ist ebenfalls möglich. Das Aufbauen des Kontaktpads kann so lange durchgeführt werden, bis dessen Oberfläche planparallel entweder zur Isolationsschicht oder zur Leitschicht ist. Hierbei kann eine Abweichung der Ebenen des Kontaktpads und der Leitschicht beziehungsweise der Isolationsschicht von weniger 10 µm und weniger als planparallel verstanden werden.

Um eine elektrische Isolation des Kontaktpads von der Leitschicht und/oder der Isolationsschicht zu ermöglichen, wird ein Abstand bzw. Ringraum zwischen Kontaktpad und Leitschicht und/oder Isolator vorgeschlagen. Der Abstand zwischen Kontaktpad und Leitschicht und/oder Isolator kann dabei zwischen 10 mm, und 0,5 mm liegen.

Der Raum zwischen dem Kontaktpad und der Leitschicht und/oder der Isolator kann frei von Füllmaterial sein. Insbesondere kann ein Luftspalt vorhanden sein. Auch ist es möglich, dass die Isolationsschicht in den Raum eingebracht wird.

Wie bereits erwähnt, kann ein Source- oder Drain-Kontakt mit einem Kontaktpad verbunden werden. Um den dazugehörigen Gate-Kontakt, der vorzugsweise entlang der gleichen Kante des Halbleiters angeordnet ist, mit der Leitschicht zu kontaktieren, kann die Leitschicht beziehungsweise die Leiterbahn der Leitschicht ein Anschlusspad aufweisen. Das Anschlusspad hat eine lötbare Oberfläche und dient zum Anschluss des Gate-Kontakts.

Sowohl das Anschlusspad als auch das Kontaktpad beziehungsweise die nebeneinander liegenden Kontaktpads können entlang einer gemeinsamen Außenkante einer Leiterplatte angeordnet sein.

Zur Kontaktierung eines Halbleiters an der Leiterplatte sind sowohl Anschlusspads als auch Kontaktpads vorgesehen. Die Kontaktpad können mehrere elektrisch gleichartige Pins, i.e. mehrere oder alle Pins eines Drain- oder Source Kontakts, eines Halbleiters kontaktieren, indem nebeneinander mehrere Kontaktpads vorgesehen sind. Die Kontaktpad können mit einem oder mehreren Pins eines Source- oder Drain-Kontakts eines Halbleiters kontaktiert sein. Daneben dazu kann das Anschlusspad mit einem Pin eines Gate-Kontakts des Halbleiters elektrisch kontaktiert sein. Die Lötbereiche des Kontaktpads als auch das Anschlusspad sind kongruent zu den Abständen der Kontaktpins des Halbleiters voneinander beabstandet.

Eine hervorragende elektrische als auch thermische Verbindung zwischen Trägerplatte und Halbleiter wird durch metallische Beschichtung des Kontaktpads ermöglicht. Insofern wird vorgeschlagen, dass der Source- oder Drain-Kontakt elektrisch mit der Trägerplatte durch das Kontaktpad kontaktiert ist. Auch wird vorgeschlagen, dass die Trägerplatte ein freies Ende zur Kontaktierung des Source- oder Drain-Kontakts mit einer elektrischen Schaltung aufweist. Entsprechend der Leiterplatte nach einem der Ansprüche 1 bis 6 ist auch hier eine Kontaktierung mit einem großen Leiterquerschnitt notwendig. Entsprechende Kontakte an dem freien Ende der Trägerplatte können somit vorgesehen sein.

Auch wird vorgeschlagen, dass der Gate-Kontakt elektrisch mit der Leitschicht kontaktiert ist. Auf der Leitschicht können Leiterbahnen vorgesehen sein, insbesondere aus der Leitschicht geätzt sein und zumindest Teile einer Steuerschaltung für den Gate-Kontakt aufnehmen. Somit können auf der Leiterplatte unmittelbar zumindest Teile einer Steuerschaltung für den Halbleiter vorgesehen sein.

Gemäß einem Ausführungsbeispiel wird vorgeschlagen, dass zumindest ein Anschlusspad und zumindest ein Kontaktpad im Bereich einer Außenkante der Leiterplatte angeordnet sind. Insbesondere entlang einer Längskante der Leiterplatte können Anschlusspad und Kontaktpad nebeneinander angeordnet sein. Das Anschlusspad kann unmittelbar neben dem Kontaktpad an einer Außenkante der Leiterplatte angeordnet sein.

Um ein Verkanten eines aufgelöteten Halbleiters zu verhindern, wird vorgeschlagen, dass das Anschlusspad und das Kontaktpad im Wesentlichen planparallel zueinander angeordnet sind. Die Lötbereiche von Anschlusspad und Kontaktpad können so gestaltet sein, dass sie im Wesentlichen in einer Ebene liegen.

Gemäß einem Ausführungsbeispiel wird vorgeschlagen, dass die Trägerplatte eine Stärke von zumindest 1 mm, vorzugsweise von zumindest 1,5 mm, aber weniger als 50 mm hat. Auch wird vorgeschlagen, dass der Leiterquerschnitt der Trägerplatte über 2,5 mm² ist.

Wie bereits erwähnt, können die Trägerplatten aus Kupfer oder einer Legierung davon gebildet sein. Auch ist es möglich, die Trägerplatte aus Aluminium oder aus einer Aluminiumlegierung zu bilden und mit Kupfer zu beschichten.

Die jeweilige Trägerplatte kann an einem Ende frei von der Isolationsschicht und/oder dem Isolator sein. An diesem freien Ende kann die Trägerplatte beispielsweise verzinnt und/oder vernickelt sein. Auch kann im Bereich des freien Endes ein elektrischer Anschlusspunkt vorgesehen sein, um ein Hochstromkabel aufzunehmen.

Ein weiterer Aspekt ist eine Schaltung, insbesondere eine Schaltung mit einer ersten Leiterplatte nach Anspruch 1 und einer zweiten Leiterplatte nach Anspruch 7. Die Schaltung zeichnet sich dadurch aus, dass die beiden Leiterplatten einander zugewandt nebeneinander angeordnet sind und durch einen Spalt voneinander beabstandet sind. Durch den Spalt können die beiden Leiterplatten voneinander isoliert sein. Auch kann der Spalt ein Luftspalt sein. Der Spalt kann auch mit einem Isolationsmaterial gefüllt sein.

Den Spalt überbrückend können die Leiterplatten miteinander durch zumindest einen Halbleiter, der auf den Kontaktpads, den Anschlusspad und der metallischen Beschichtung elektrisch und mechanisch fixiert ist, mechanisch und elektrisch verbunden sein.

Die den Anschlussbereich aufweisende Außenkante der ersten Leiterplatten kann parallel zu einer den Kontaktbereich aufnehmenden Außenkante der zweiten Leiteplatte verlaufen. Dies erleichtert die mechanische Verbindung der Leiterplatten miteinander über den Halbleiter.

Der Kontaktbereich und/oder das Kontaktpad kann an der der ersten Leiterplatte zugewandten Außenkante der zweiten Leiterplatte angeordnet sein. Dies erleichtert ebenfalls die mechanische Verbindung der Leiterplatten mit Hilfe des Halbleiters. Dies gilt ebenso, wenn der Anschussbereich und/oder die metallische Beschichtung an der der zweiten Leiterplatte zugewandten Außenkante der ersten Leiterplatte angeordnet ist.

In den genannten Fällen kann die erste Leiterplatte dann wie die zweite Leiterplatte gemeinsam mit zumindest einem gleichen Halbleiter bestückt sein. Der Halbleiter kann mit zumindest einem Pin an der ersten Leiterplatte elektrisch und mechanisch fixiert sein und mit einem zweiten Pin an der zweiten Leiterplatte. Unschädlich für den gegenständlichen Gedanken ist, wenn die Leiterplatten nach der Bestückung in einem Gehäuse oder einem Träger gehalten sind und dadurch zusätzlich mechanisch zueinander fixiert sind.

Wie bereits erwähnt, kann sowohl die metallische Beschichtung der Leiterplatte nach Anspruch 1 als auch die Kontaktpads und Anschlusspads der Leiterplatte nach Anspruch 7 entlang einer jeweils gemeinsamen Außenkante angeordnet sein. Diese jeweiligen Außenkanten können einander zugewandt in der Schaltung angeordnet sein. Die Trägerplatten verlaufen im Wesentlichen parallel zueinander.

Der Spalt wird elektrisch vorzugsweise ausschließlich durch den Leistungshalbleiter mechanisch überbrückt. Insbesondere sind die Halbleiter, die mit der metallischen Beschichtung, den Kontaktpads und den Anschlusspads insbesondere SMD verlötet sind, für die mechanische Verbindung zwischen den beiden Leiterplatten verantwortlich.

Das Kontaktpad ist an der der ersten Leiterplatte zugewandten Kante der zweiten Leiterplatte angeordnet und die metallische Beschichtung der der zweiten Leiterplatte zugewandten ersten Leiterplatte angeordnet.

Das Kontaktpad der zweiten Leiterplatte und die metallische Beschichtung der ersten Leiterplatte sind einander zugewandt. Die Kontaktierung der Leiterplatten erfolgt über zumindest einen gleichen, gemeinsamen Leistungshalbleiter.

Ein Verfahren zur Herstellung einer Schaltung schlägt vor, dass eine Leiterplatte nach Anspruch 1 und eine Leiterplatte nach Anspruch 7 einer Bestückungsvorrichtung zugeführt werden. Hierbei sind die Leiterplatten beabstandet voneinander. Über den Abstand wird ein Halbleiter gelegt und anschließend mit dem Kontaktpad, dem Anschlusspad und der metallischen Beschichtung verbunden, insbesondere verlötet. Somit wird eine Bestückung der Leiterplatten derart durchgeführt, dass ein den Abstand zwischen den Leiterplatten überbrückender Halbleiter auf den Leiterplatten angeordnet wird.

Die Leiterplatten können aus zwei getrennten Trägerplatten hergestellt werden und anschließend auf einem gemeinsamen Warenträger einer Bestückungsvorrichtung zugeführt werden.

Auch ist es möglich, dass eine erste Leiterplatte nach Anspruch 1 zusammen mit einer zweiten Leiterplatte nach Anspruch 7 zunächst auf einer monolithischen Trägerplatte geformt wird. Dabei kann z.B. eine Trägerplatte zunächst derart aufgetrennt werden, dass sich ein Spalt zwischen den Leiterplatten bildet, wobei dieser Spalt durch Stege der Trägerplatte überbrückt ist und die Trägerplatte somit monolithisch bleibt. Anschließend können auf einer ersten Leiterplatte die Kontakte auf den Anschlussflächen hergestellt werden. Auf einer zweiten Leiterplatte können die Kontaktpads auf einer Kontaktfläche, die Anschlusspads und die Leiterbahnen geformt werden. Anschließend wird die Trägerplatte mit zumindest einem Halbleiter bestückt, wobei dieser die einander gegenüberliegenden Kontakte und Kontaktpads bzw. Anschlusspads miteinander verbindet. Die dann noch bestehenden Stege können anschließend entfernt, z.B. herausgefräst werden. Die Trägerplatte ist nun zumindest zweiteilig, wobei zwei daraus geformte Leiterplatten über den Halbleiter mechanisch und elektrisch miteinander verbunden sind.

Vorzugsweise ist eine der Leiterplatten U-förmig und die zweite Leiterplatte ist innerhalb der U-Form angeordnet. Insbesondere hat die Leiterplatte nach Anspruch 1 eine U-Form und die Kontakte bzw. die metallische Beschichtung sind an den Schenkeln nach jeweils nach Innen weisend angeordnet. Die Leiterplatte nach Anspruch 7 ist zwischen den das U formenden Schenkeln angeordnet und die Kontaktpads und Anschlusspads sind an distalen Kanten jeweils in Richtung der Schenkel weisend angeordnet.

Nachfolgend wird der Gegenstand anhand einer Ausführungsbeispiele zeigenden Zeichnung näher erläutert. In der Zeichnung zeigen:
- Fig. 1: eine Draufsicht auf eine Leiterplatte mit metallischen Beschichtungen;
- Fig. 2: eine Schnittansicht der Leiterplatte nach Figur 1;
- Fig. 3: eine weitere Schnittansicht der Leiterplatte nach Figur 3;
- Fig. 4: eine Draufsicht auf eine Leiterplatte mit Kontaktpads und Anschlusspads;
- Fig. 5: eine Schnittansicht einer Leiterplatte nach Figur 4;
- Fig. 6: eine Schnittansicht einer Leiterplatte nach Figur 4;
- Fig. 7: eine Draufsicht auf zur Bestückung nebeneinander angeordneter Leiterplatten nach Figur 1 und Figur 4;
- Fig. 8: eine Draufsicht auf zwei mit einem Leistungshalbleiter bestückte Leiterplatten;
- Fig. 9: eine Draufsicht auf eine monolithische Trägerplatte mit zwei Leiterplatten vor dem Auftrennen der Stege.

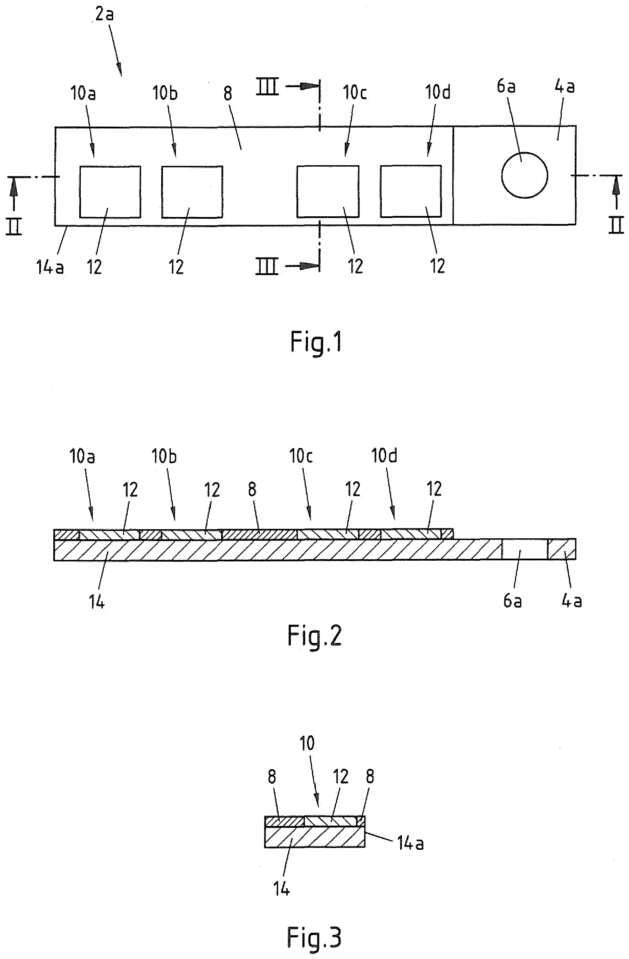

Figur 1 zeigt eine erste Leiterplatte 2a. Diese Leiterplatte kann eine Hochstromleiterplatte mit einer Stromtragfähigkeit von über 10 Ampere, vorzugsweise von über 300 Ampere sein. Hierzu hat die Leiterplatte eine metallische Trägerplatte. Die Trägerplatte hat einen Leitungsquerschnitt von über 5 mm², vorzugsweise über 15 mm², insbesondere über 35 mm².

In der Draufsicht auf die Leiterplatte 2a ist zu erkennen, dass an einem ersten freien Ende 4a die Trägerplatte einen Anschluss 6a aufweist. Im gezeigten Fall ist dies eine Bohrung, die zur Aufnahme eines Kabels dienen kann. Am freien Ende 4a ist die Trägerplatte 2a z.B. mit Zinn beschichtet, insbesondere aber frei von einer Isolationsschicht.

Ein überwiegender Teil, insbesondere mehr als zwei Drittel der Fläche der Leiterplatte 2a ist isoliert und weist somit eine Isolationsschicht 8 auf. Die Isolationsschicht 8 ist vorzugsweise ein Lötstopplack, der auf die Leiterplatte 2a aufgedruckt wird. Dies kann beispielsweise mittels Siebdruckverfahren erfolgen.

Wie zu erkennen ist, ist die Isolationsschicht 8 in vier Anschlussbereichen 10a-10d nicht vorhanden. An Stelle der Isolationsschicht 8 ist in den Anschlussbereichen 10a-10d eine metallische Beschichtung 12 aufgebracht. Die metallische Beschichtung 12 ist vorzugsweise eine Zinnschicht oder eine andere zum Löten geeignete Schicht.

Während des Bedruckens der Leiterplatte 2a mit der Isolationsschicht 8 werden die Anschlussbereiche 10a-10d ausgespart und anschließend wird die metallische Beschichtung 12 aufgebracht. Die metallische Beschichtung 12 kann einen Kontakt für den Halbleiter bilden. Der Aufbau der Leiterplatte 2a ist im Schnitt II-II gemäß Figur 2 näher erläutert.

In der Figur 2 ist zu erkennen, dass die Leiterplatte 2a eine metallische Trägerplatte 14 aufweist. Die metallische Trägerplatte 14 kann aus Kupfer oder Legierungen davon gebildet sein. Auch ist es möglich, dass die metallische Trägerplatte 14 im Kern aus Aluminium oder Legierungen davon aufweist und mit Kupfer oder Legierungen beziehungsweise Zinn beschichtet ist.

Ferner ist zu erkennen, dass auf der metallischen Trägerplatte 14 die Isolationsschicht 8 aufgetragen ist. In den Anschlussbereichen 10a-d ist die metallische Trägerplatte 14 frei von der Isolationsschicht 8 und die metallische Beschichtung 12 ist aufgebracht. Die metallische Beschichtung 12 ist unmittelbar auf der metallischen Trägerplatte 14 aufgebracht. In der Figur 2 ist zu erkennen, dass die metallische Beschichtung 12 im Wesentlichen entlang einer Oberfläche planparallel zu der Oberfläche der Isolationsschicht 8 verläuft.

Ferner ist zu erkennen, dass die Anschlussbereiche 10a-d beispielhaft jeweils in Gruppen aus zwei Anschlussbereichen 10a, b und 10c, d zueinander zugeordnet vorgesehen sind. Die räumliche Anordnung entlang der Längsachse der Leiterplatte 2a der Anschlussbereiche 10a-d ist abhängig von der nachfolgenden Bestückung.

Die Figur 3 zeigt den Schnitt III-III gemäß der Figur 1. Zu erkennen ist erneut die metallische Trägerplatte 14 und die Isolationsschicht 8. Ferner ist zu erkennen, dass an einer Längs- bzw. Außenkante 14a der Trägerplatte 14 ein jeweiliger Anschlussbereich 10a-d vorgesehen ist. Es ist zu erkennen, dass der Anschlussbereich 10 nicht unmittelbar mit der Längskante 14a abschließt, sondern dass zwischen der Beschichtung 12 und der Längskante 14a ein relativ schmaler Bereich der Isolationsschicht 8 verbleibt. Dieser Bereich ist vorzugsweise kleiner als 1 mm, vorzugsweise kleiner als 0,5 mm, insbesondere kleiner als 0,1 mm. Es ist jedoch auch möglich, dass die metallische Beschichtung 12 bis an die Längskante 14a heran reicht.

Die Leiterplatte 2a eignet sich zum Anschluss an einen Drain- oder Source-Kontakt eines Transistors, insbesondere eines Hochleistungstransistors in SMD-Bauweise. Ein solcher weist auf seiner Unterseite einen großflächigen Source- oder Drain-Kontakt auf, der mit der metallischen Beschichtung 12 verlötet werden kann. Dadurch, dass die metallische Beschichtung 12 vorzugsweise im Wesentlichen kongruent zu der Fläche des Source- oder Drain Kontakts ist, kann dieser großflächig auf dem Anschlussbereich 10 aufliegen und neben einem guten elektrischen Kontakt erfolgt eine gute thermische Ableitung von thermischer Energie aus dem Halbleiter über dessen Drain- oder Source-Kontakt in die Trägerplatte 14.

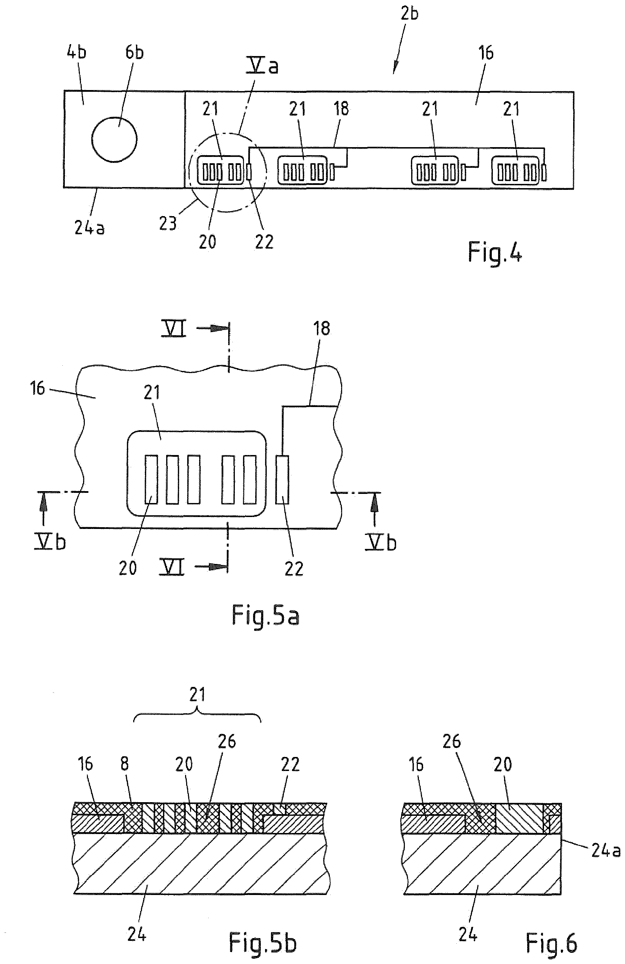

Figur 4 zeigt eine zweite Leiterplatte 2b, die ebenfalls ein freies Ende 4b und einen Anschluss 6b aufweist. Das freie Ende 4b ist entsprechend dem freien Ende 4a gestaltet. Ferner ist zu erkennen, dass ein Isolator, z.B. ein Kunststoff, ein Prepreg oder dergleichen 16 auf Leiterplatte 2b aufgebracht ist. Dieser Isolator 16 kann zusammen mit einer Leitschicht auf eine metallische Trägerplatte 24 aufgepresst werden. Anschließend kann mittels Belichtung und Ätzen aus der Leitschicht eine Leiterbahn 18 erstellt werden. Die Leiterbahn 18 verläuft entsprechend einer Schaltungstopologie auf dem Isolator 16 und dient zum Anschluss von Steuerelektronik (nicht dargestellt).

Einer Außenkante zugewandt können Kontaktpads 20 und Anschlusspads 22 vorgesehen sein. Insbesondere kann das Anschlusspad 22 mit der Leiterbahn 18 unmittelbar kontaktiert sein. Die Kontaktpads 20 sind jedoch in einer fensterartigen Durchbrechung 21 des Isolators 16 angeordnet. In dieser Durchbrechung 21 ist die Trägerplatte 24 zunächst freigelegt. Eine Isolationsschicht 8 kann später, nachdem die Kontaktpads 20 gebildet sind, aufgebracht werden. In der Durchbrechung 21 sind die Kontaktpads 20 durch einen Isolationsspalt, insbesondere einen Luftspalt, von dem Isolator 16 als auch den Leiterbahnen 18 beziehungsweise der Leitschicht beabstandet. Wie zu erkennen ist, sind in einer Durchbrechung 21 eine Mehrzahl von Kontaktpads 20 vorgesehen. Unmittelbar neben einer Durchbrechung 21, auf dem Isolator 16, kann ein dem Kontaktpads 20 zugeordnetes Anschlusspad 22 vorgesehen sein. Die Anzahl der Kontaktpads 20 als auch des Anschlusspads 22 kann entsprechend der Anzahl von Kontaktpins eines Leistungshalbleiters gewählt werden. Insbesondere hat ein Transistor zur thermischen Ableitung eine Mehrzahl von Source- oder Drain-Kontaktpins und genau einen Gate-Kontaktpin. Der Gate-Kontaktpin kann mit dem Anschlusspad 22 verbunden werden und die Source- beziehungsweise Drain-Kontaktpins mit den Kontaktpads 20. Um zu verhindern, dass die Kontaktpads 20 elektrisch mit dem Anschlusspad 22 kurzgeschlossen werden, muss der elektrisch leitende Bereich der Kontaktpads 20 isoliert von der Leiterbahn 18 sein. Hierzu kann, nachdem die Isolationsschicht 16 als auch die Leitschicht auf die Trägerplatte 14 aufgepresst wurde, jeweils einem Anschlusspad 22 zugeordnete Durchbrechung 21 bis zur Trägerplatte 14 hindurch gefräst oder gebohrt werden. In der Durchbrechung 21 kann anschließend ein Fotoresist belichtet werden. Der belichtete Bereich kann der Fläche der Kontaktpads 20 entsprechen. Dieser Bereich des Fotoresist wird entfernt und anschließend unmittelbar auf der Trägerplatte 24 die Kontaktpads aufgebaut, z.B. chemisch. Dieser Aufbau ist in Detail 23 in Figur 5a und 5b dargestellt.

Figur 5b zeigt das Detail 23 im Schnitt V-V darstellt. Figur 5 zeigt eine metallische Trägerplatte 24, die entsprechend der metallischen Trägerplatte 14 gestaltet sein kann. Auf die metallische Trägerplatte 24 kann der Isolator 16 und eine nicht dargestellte Leitschicht aufgepresst werden. Im Anschluss kann die Leitschicht belichtet und geätzt werden, sodass sich Leiterbahnen 18 auf dem Isolator 16 bilden.

Die Isolator 16 wird in der Durchbrechung 21 entfernt, z.B. gebohrt oder gefräst. Die Leitschicht kann in der Durchbrechung 21 ebenfalls entfernt, z.B. gebohrt oder gefräst oder insbesondere geätzt werden. Anschließend kann innerhalb der Durchbrechung 21 durch thermische und/oder galvanische Prozesse zumindest ein Kontaktpad 20 auf die metallische Trägerplatte 24 aufgebracht werden. Wie zu erkennen ist, ist die Durchbrechung 21 so geformt, dass das Kontaktpad 20 beabstandet von dem Isolator 16 ist. Ferner ist kein Kontakt zu der Leitschicht vorhanden und auch kein Kontakt zu den Leiterbahnen 18 vorhanden. Nachdem das Kontaktpad 20 gebildet wurde, kann auch im Bereich der Durchbrechung 21 eine Isolationsschicht 8, insbesondere wie auch auf dem Rest der Leiterplatte 2b, mit Ausnahme des Endes 4b, aufgetragen werden.

In Kontakt mit den Leiterbahnen 18 ist das Anschlusspad 22, welches durch Belichten und Ätzen einer Leitschicht hergestellt werden kann. Die Kontaktpads 20 und Anschlusspads 22 sind lötbar beschichtet und/oder aus lötfähigem Material gebildet. Wie zu erkennen ist, sind die Kontaktpads 20 an ihrer nach außen weisenden Oberfläche im Wesentlichen parallel zu der Isolationsschicht 16 und vorzugsweise planparallel zu den Leiterbahnen 18 und dem Anschlusspad 22.

Figur 5a zeigt das Detail 23 in Draufsicht. Zu erkennen ist, dass in einer Durchbrechung 21 mehrere Kontaktpads 22 in Abstand zu dem Isolator 16 vorgesehen sind. Der Isolator 16 ist in der Durchbrechung 21 entfernt und das Metall der Trägerplatte kann unmittelbar beschichtet werden. Auch ist zu erkennen, dass seitlich von der Durchbrechung 21 das Anschlusspad 22 angeordnet ist.

In der Figur 6 ist der Schnitt VI-VI der Figur 4 dargestellt. Entsprechend den metallischen Beschichtungen 12 sind auch die Kontaktpads 20 einer Außen- bzw. Längskante 24a zugewiesen, jedoch vorzugsweise von dieser beabstandet durch einen Steg des Isolators 16. Dieser Steg ist entsprechend der Figur 3 sehr schmal, vorzugsweise kleiner als 1 mm. Der Steg kann aber auch entfallen und die Kontaktpads 20 können unmittelbar an der Längskante 24a abschließen.

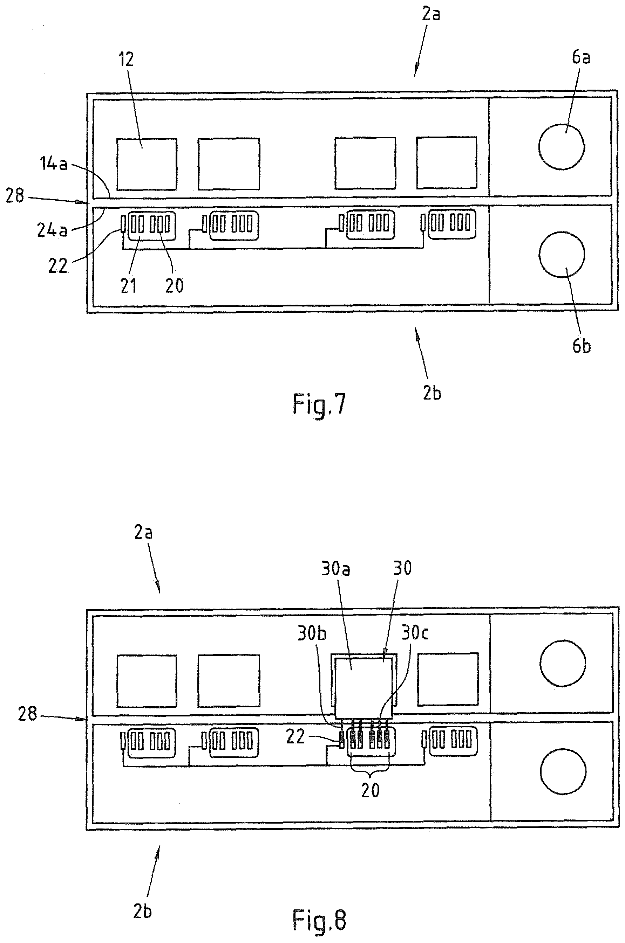

Die entsprechend Figur 1 und Figur 4 gefertigten Leiterplatten 2a, 2b werden durch einen Luftspalt 28 beabstandet voneinander angeordnet. Hierbei sind, wie in Figur 7 zu erkennen, die Längskanten 14a und 24a einander zugewandt. Ferner sind entlang der Längskanten 14a, 24a die metallischen Beschichtungen 12 als auch die Kontaktpads 20 und Anschlusspads 22 in einem gleichen Abstand von den Anschlüssen 6a, 6b vorgesehen. Das führt dazu, dass wenn die Leiterplatten 2a, 2b einander zugeordnet nebeneinander angeordnet werden die metallischen Beschichtungen 12 den Kontaktpads 20 und Anschlusspads 22 zugewandt sind.

Die entsprechend der Figur 7 angeordneten Leiterplatten 2a, 2b werden anschließend einer Bestückungsvorrichtung zugeführt und mit Transistoren 30 bestückt. Wie zu erkennen ist, ist der Luftspalt 28 zwischen den Trägerplatten 14, 24 mechanisch als auch elektrisch durch den Transistor 30 überbrückt, wie in Figur 8 zu erkennen ist.

Der Transistor 30 verfügt auf seiner einen Seite über einen Drain-Anschluss 30a. Dieser ist vorzugsweise großflächig auf der Unterseite des Transistors 30 angeordnet. Der Drain-Anschluss 30a wird mittels Löttechnik auf der metallischen Beschichtung 12 aufgelötet. Auf der gegenüberliegenden Seite ist der Transistor 30 mit einem Gate-Kontaktpin 30b und fünf Source-Kontaktpins 30c bestückt. Der Gate-Kontaktpin 30b ist mit dem Anschlusspad 22 mittels Löten verbunden. Die Source-Kontaktpins 30c sind mittels Löten mit den Kontaktpads 20 verbunden. Durch die Verlötung des Transistor 30 auf der metallischen Beschichtung 12 beziehungsweise den Kontaktpads 20 und Anschlusspads 22 erfolgt eine mechanische Fixierung der Leiterplatten 2a, 2b zueinander. Es versteht sich, dass weiteren Transistoren ebenfalls auf den Leiterplatten 2a, 2b bestückt werden können. Außerdem versteht es sich, dass die Leiterbahnen 18 dazu genutzt werden können, eine Ansteuerelektronik für den Gate-Kontaktpin über die Leiterbahnen 18 zu gestalten. Es ist auch möglich, eine doppelseitige Bestückung vorzunehmen, demzufolge wären Halbleiter auf der Oberseite und der Unterseite der Leiterplatten angeordnet.

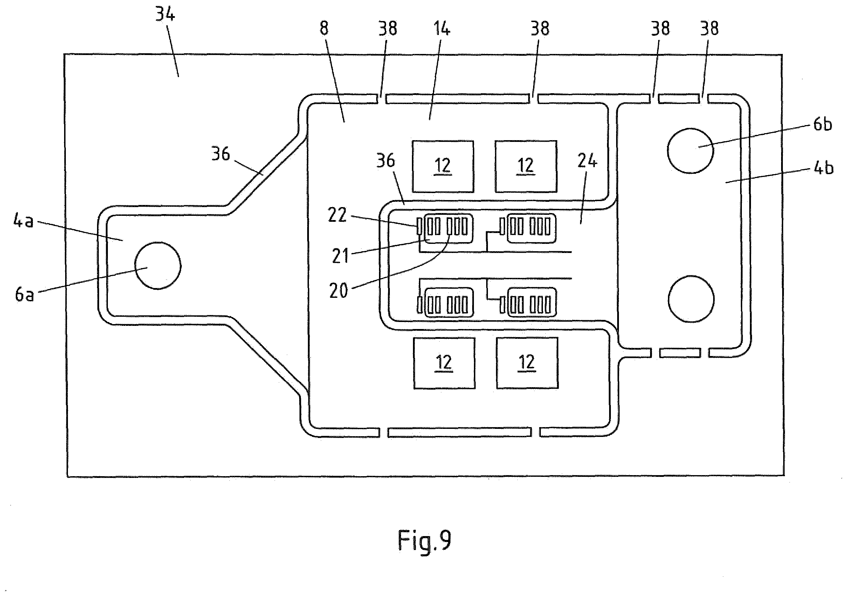

Figur 9 zeigt einen metallischen Träger 34. In diesen sind eine erste Trägerplatte 14 und eine zweite Trägerplatte 24 geformt. Dies kann z.B. durch Fräsen entsprechender Spalte 36 in dem Träger 34 erfolgen. Zu erkennen ist, dass der Träger 34 monolithisch ist und die Trägerplatten 14 und 34 durch Stege 38 untereinander und mit dem Träger 34 mechanisch verbunden sind.

Der Träger 34 wird so bearbeitet, dass wie oben beschrieben die metallischen Beschichtungen 12 auf der Trägerplatte 14 und die Kontaktpads 20 und Anschlusspads 22 auf der Trägerplatte 24 gebildet werden. Anschließend oder davor können die Spalte 36 mit den Stegen 38 in dem Träger 34 vorgesehen werden. Zu erkennen ist, dass der Spalt 36 zwischen den Leiterplatten 14 und 24 eine U Form nachbildet. Die Leiterplatte 14 hat eine U Form und auf den Schenkeln sind die metallischen Beschichtungen 12 vorgesehen. Es versteht sich, dass der Begriff metallische Beschichtung 12 meint, dass auf dem Träger 14 eine Kontakt oder Anschluss, insbesondere ein Lötanschluss gebildet ist Die Leiterplatte 24 ist in dem U angeordnet..

Anschließend kann eine Bestückung, z.B. mittels SMD Bestückung erfolgen. Zumindest ein Transistor kann mit der metallischen Beschichtung einerseits und mit den Kontaktpads 20 und den Anschlusspads 22 verlötet werden. Nachdem das Lot ausgehärtet ist, verbinden die Transistoren die Leiterplatten 14 und 24 mechanisch und elektrisch miteinander. Die Stege 38 können entfernt werden. Die einzige mechanische und elektrische Verbindung zwischen den Trägerplatten 14 und 24 ist dann durch die Transistoren gebildet.

## Patentansprüche

1. Leiterplatte (2a) mit
- einer metallischen Trägerplatte (14),
- einer die metallische Trägerplatte (14) auf einer Oberfläche elektrisch isolierenden Isolationsschicht (8), wobei die Trägerplatte (14) in zumindest einem Anschlussbereich (10a-10d) frei von der Isolationsschicht (8) ist, wobei
- die Trägerplatte (14) im Anschlussbereich (10a-10d) metallisch beschichtet ist,
- wobei auf der metallischen Beschichtung (12) des Anschlussbereichs (10a-10d) ein Kontakt eines Halbleiterbauelements elektrisch kontaktiert ist und
- **dadurch gekennzeichnet, dass** nichtleitende Bereiche des Halbleiterbauelements auf der Isolationsschicht (8) aufliegen.

2. Leiterplatte (2a) nach Anspruch 1, **dadurch gekennzeichnet, dass** die Isolationsschicht (8) ein Lötstopplack ist und/oder dass die Isolationsschicht (8) auf die Trägerplatte (14) aufgedruckt ist.

3. Leiterplatte (2a) nach einem der vorangehenden Ansprüche, **dadurch gekennzeichnet, dass** die metallische Beschichtung (12) eine Zinnschicht ist, und/oder dass die metallische Beschichtung (12) im Wesentlichen planparallel zur Oberfläche der Isolationsschicht (8) ist.

4. Leiterplatte (2a) nach einem der vorangehenden Ansprüche, **dadurch gekennzeichnet, dass** der Kontakt elektrisch mit der Trägerplatte (14) durch die metallische Beschichtung (12) kontaktiert ist und dass die Trägerplatte (14) ein freies Ende 4a zur Kontaktierung des Kontakts mit einer elektrischen Schaltung aufweist.

5. Schaltung mit einer ersten Leiterplatte (2a) nach Anspruch 1 und einer zweiten Leiterplatte (2b) mit
- einer metallischen Trägerplatte (14),
- einen die metallische Trägerplatte (14) auf einer Oberfläche elektrisch isolierenden Isolator (16),
- einer auf dem Isolator (16) aufgebrachten Leitschicht,
**dadurch gekennzeichnet,**
- **dass** der Isolator (16) sowie die Leitschicht in zumindest einem Kontaktbereich durchbrochen sind und
- **dass** in dem Kontaktbereich zumindest ein metallisches Kontaktpad (20) auf der Trägerplatte (24) angeordnet ist, derart, dass das Kontaktpad (20) umlaufend beabstandet dem der Isolator (16)und der Leitschicht ist und
- **dass** die erste Leiterplatten (2a) von der zweiten Leiterplatte (2b) durch einen Luftspalt oder ein Isolationsmaterial beabstandet ist.

6. Schaltung nach Anspruch 5, **dadurch gekennzeichnet, dass** das Kontaktpad (20) der zweiten Leiterplatte (2b) im Wesentlichen planparallel zu der Leitschicht der zweiten Leiterplatte (2b) ist, und/oder dass das Kontaktpad (20) der zweiten Leiterplatte (2b) in einem belichteten Bereich des Kontaktbereichs der zweiten Leiterplatte (2b) angeordnet ist.

7. Schaltung nach einem der Ansprüche 5 oder 6, **dadurch gekennzeichnet, dass** der Kontaktbereich der zweiten Leiterplatte (2b) zur Aufnahme von zumindest zwei Kontaktpads (20) gebildet ist und dass der Kontaktbereich der zweiten Leiterplatte (2b) frei von dem Isolator (16) ist und/oder dass zwischen dem Kontaktpad (20) der zweiten Leiterplatte (2b) und der Leitschicht der zweiten Leiterplatte (2b) und/oder der Isolationsschicht (8) der zweiten Leiterplatte (2b) ein Ringraum angeordnet ist insbesondere dass der Abstand zwischen Kontaktpad (20) der zweiten Leiterplatte (2b) und Leitschicht der zweiten Leiterplatte (2b) weniger als 1mm, insbesondere weniger als 0,5mm, vorzugsweise weniger als 0,1mm beträgt.

8. Schaltung nach einem der Ansprüche 5 bis 7, **dadurch gekennzeichnet, dass** der zwischen dem Kontaktpad (20) der zweiten Leiterplatte (2b) und der Leitschicht der zweiten Leiterplatte (2b) und/oder dem Isolator (16) der zweiten Leiterplatte (2b) vorhandene Raum frei von Füllmaterial und/oder mit einer Isolationsschicht (8) beschichtet ist.

9. Schaltung nach einem der Ansprüche 5 bis 8, **dadurch gekennzeichnet, dass** zumindest ein Anschlusspad (22) der zweiten Leiterplatte (2b) elektrisch mit der Leitschicht der zweiten Leiterplatte (2b) verbunden ist, und/oder dass das Kontaktpad (20) der zweiten Leiterplatte (2b) mit einem Source- oder Drain-Kontakt eines Leistungshalbleiters elektrisch kontaktiert ist und dass das Anschlusspad (22) der zweiten Leiterplatte (2b) mit einem Gate-Kontakt des Leistungshalbleiters elektrisch kontaktiert ist

10. Schaltung nach Anspruch 9, **dadurch gekennzeichnet, dass** der Source- oder Drain-Kontakt elektrisch mit der Trägerplatte (24) der zweiten Leiterplatte (2b) durch das Kontaktpad (20) der zweiten Leiterplatte (2b) kontaktiert ist und/oder dass die Trägerplatte (24) der zweiten Leiterplatte (2b) ein freies Ende 4b zur Kontaktierung des Source- oder Drain-Kontakts mit einer elektrischen Schaltung aufweist und/oder dass der Gate-Kontakt elektrisch mit der Leitschicht der zweiten Leiterplatte (2b) kontaktiert ist und dass auf der Leitschicht der zweiten Leiterplatte (2b) Leiterbahnen (18) für eine Steuerschaltung des Gate-Kontakts gebildet sind.

11. Schaltung nach einem der Ansprüche 5 bis 10, **dadurch gekennzeichnet, dass** zumindest ein Anschlusspad (22) der zweiten Leiterplatte (2b) und/oder zumindest ein Kontaktpad (20) der zweiten Leiterplatte (2b) im Bereich einer Kante der zweiten Leiterplatte (2b) angeordnet sind und/oder dass der Kontaktbereich der zweiten Leiterplatte (2b) entlang einer Längskante (24a) der zweiten Leiterplatte (2b) angeordnet ist.

12. Schaltung nach einem der Ansprüche 5 bis 11, **dadurch gekennzeichnet, dass** das Anschlusspad (22) der zweiten Leiterplatte (2b) und das Kontaktpad (20) der zweiten Leiterplatte (2b) im Wesentlichen planparallel zueinander angeordnet sind.

13. Schaltung nach einem der vorangehenden Ansprüche, **dadurch gekennzeichnet, dass** die Trägerplatte (24) der zweiten Leiterplatte (2b) eine Stärke von zumindest 1mm, vorzugsweise von zumindest 1,5mm, aber weniger als 50mm hat und/oder dass die Trägerplatte (24) der zweiten Leiterplatte (2b) aus Kupfer oder einer Legierung davon gebildet ist oder dass die Trägerplatte (24) der zweiten Leiterplatte (2b) aus Aluminium oder einer Legierung davon gebildet ist und eine Kupferbeschichtung aufweist und/oder dass die Trägerplatte (24) der zweiten Leiterplatte (2b) an einem Ende frei von der Isolationsschicht (8) ist und/oder dass das freie Ende (4b) der Trägerplatte (24) der zweiten Leiterplatte (2b) einen elektrischen Anschlusspunkt bildet.

14. Schaltung nach Anspruch 5, **dadurch gekennzeichnet, dass** die Leiterplatten (2a, b) durch zumindest einen Halbleiter mechanisch miteinander verbunden sind und/oder die den Anschlussbereich (10a-10d) aufweisende Außenkante einer ersten Leiterplatten (2a) parallel zu einer den Kontaktbereich aufnehmenden Außenkante einer zweiten Leiterplatte (2b) verläuft und/oder dass der Kontaktbereich und/oder das Kontaktpad (20) an der der ersten Leiterplatte (2a) zugewandten Außenkante der zweiten Leiterplatte (2b) angeordnet ist und/oder dass der Anschussbereich und/oder die metallische Beschichtung (12) an der der zweiten Leiterplatte (2b) zugewandten Außenkante der ersten Leiterplatte (2a) angeordnet ist und/oder dass der Kontaktbereich und/oder das Kontaktpad (20) der zweiten Leiterplatte (2b) und der Anschlussbereich (10a-10d) und/oder die metallische Beschichtung (12) der ersten Leiterplatte (2a) einander zugewandt sind und/oder dass die erste Leiterplatte (2a) und die zweite Leiterplatte (2b) gemeinsam mit zumindest einem gleichen Halbleiter bestückt sind.

15. Verfahren zur Herstellung einer Schaltung nach Anspruch 5, **dadurch gekennzeichnet, dass** den Abstand zwischen den Leiterplatten (2a, b) überbrückend eine Bestückung mit zumindest einem Halbleiter durchgeführt wird.

16. Verfahren nach Anspruch 15, **dadurch gekennzeichnet, dass** die erste Leiterplatte (2a) nach Anspruch 1 und die zweite Leiterplatte (2b) nach Anspruch 5 auf einem gemeinsamen Warenträger einer Bestückungsvorrichtung zugeführt werden.

17. Verfahren nach Anspruch 16, **dadurch gekennzeichnet, dass** eine erste Leiterplatte (2a) nach Anspruch 1 und eine zweite Leiterplatte (2b) nach Anspruch 5 zunächst auf einer monolithischen Trägerplatte (14) geformt werden, dass vor oder nach der Bestückung die Trägerplatte (14) die beiden Leiterplatten formend aufgetrennt wird.

18. Verfahren nach Anspruch 17, **dadurch gekennzeichnet, dass** die Leiterplatten (2a, b) durch Verbindungsstege der Trägerplatte (14) miteinander verbunden sind.

## Claims

1. Printed circuit board (2a) with
- a metallic carrier plate (14),
- an insulation layer (8) electrically insulating the carrier plate (14) on a surface, wherein the carrier plate (14) is free from the insulation layer (8) in at least one connecting region (10a-10d), wherein
- the carrier plate (14) is metallically coated in the connecting region (10a-10d), wherein
- a contact of a semiconductor component is in electrical contact on the metallic coating (12) of the connecting region (10a-10d), and
**characterised in that**
- non-conducting regions of the semiconductor component rest on the insulation layer (8).

2. Printed circuit board (2a) according to Claim 1, **characterised in that** the insulation layer (8) is a solder resist and/or that the insulation layer (8) is printed onto the carrier plate (14).

3. Printed circuit board (2a) according to any one of the preceding claims, **characterised in that** the metallic coating (12) is a layer of tin, and/or that the metallic coating (12) is substantially plane parallel to the surface of the insulation layer (8).

4. Printed circuit board (2a) according to any one of the preceding claims, **characterised in that** the contact is in electrical contact with the carrier plate (14) via the metallic coating (12) and that the carrier plate (14) has a free end (4a) for contacting the contact with an electrical circuit.

5. Circuit with a first printed circuit board (2a) according to Claim 1 and a second printed circuit board (2b) with
- a metallic carrier plate (14),
- an insulator (16) electrically insulating the metallic carrier plate (14) on a surface,
- a conductive layer applied to the insulator (16),
**characterised in that**
- the insulator (16) and also the conductive layer are perforated in at least one contact region, and
- that in the contact region at least one metallic contact pad (20) is arranged on the carrier plate (24) in such a way that the contact pad (20) is spaced circumferentially from the insulator (16) and the conductive layer, and
- that the first printed circuit board (2a) is spaced from the second printed circuit board (2b) by an air gap or an insulating material.

6. Circuit according to Claim 5, **characterised in that** the contact pad (20) of the second printed circuit board (2b) is substantially plane parallel to the conductive layer of the second printed circuit board (2b), and/or that the contact pad (20) of the second printed circuit board (2b) is arranged in an exposed area of the contact region of the second printed circuit board (2b).

7. Circuit according to any one of Claims 5 and 6, **characterised in that** the contact region of the second printed circuit board (2b) is formed to accommodate at least two contact pads (20) and that the contact region of the second printed circuit board (2b) is free from the insulator (16) and/or that an annular space is arranged between the contact pad (20) of the second printed circuit board (2b) and the conductive layer of the second printed circuit board (2b), in particular that the distance between the contact pad (20) of the second printed circuit board (2b) and the conductive layer of the second printed circuit board (2b) is less than 1mm, in particular less than 0.5mm, preferably less than 0.1mm.

8. Circuit according to any one of Claims 5 to 7, **characterised in that** the existing space between the contact pad (20) of the second printed circuit board (2b) and the conductive layer of the second printed circuit board (2b) and/or the insulator (16) of the second printed circuit board (2b) is free of filler material and/or is coated with an insulation layer (8).

9. Circuit according to any one of Claims 5 to 8, **characterised in that** at least one connecting pad (22) of the second printed circuit board (2b) is electrically connected to the conductive layer of the second printed circuit board (2b), and/or that the contact pad (20) of the second printed circuit board (2b) is in electrical contact with a source or drain contact of a power semiconductor, and that the connecting pad (22) of the second printed circuit board (2b) is in electrical contact with a gate contact of the power semiconductor.

10. Circuit according to Claim 9, **characterised in that** the source or drain contact is in electrical contact with the carrier plate (24) of the second printed circuit board (2b) through the contact pad (20) of the second printed circuit board (2b) and/or that the carrier plate (24) of the second printed circuit board (2b) has a free end (4b) for contacting the source or drain contact with an electrical circuit and/or that the gate contact is in electrical contact with the conductive layer of the second printed circuit board (2b) and that conductive tracks (18) for a control circuit of the gate contact are formed on the conductive layer of the second printed circuit board (2b).

11. Circuit according to any one of Claims 5 to 10, **characterised in that** at least one connecting pad (22) of the second printed circuit board (2b) and/or at least one contact pad (20) of the second printed circuit board (2b) are arranged in the region of an edge of the second printed circuit board (2b) and/or that the contact region of the second printed circuit board (2b) is arranged along a longitudinal edge (24a) of the second printed circuit board (2b).

12. Circuit according to any one of Claims 5 to 11, **characterised in that** the connecting pad (22) of the second printed circuit board (2b) and the contact pad (20) of the second printed circuit board (2b) are arranged substantially plane parallel to one another.

13. Circuit according to any one of the preceding claims, **characterised in that** the carrier plate (24) of the second printed circuit board (2b) has a thickness of at least 1mm, preferably of at least 1.5mm, but less than 50mm, and/or that the carrier plate (24) of the second printed circuit board (2b) is formed from copper or an alloy thereof or that the carrier plate (24) of the second printed circuit board (2b) is formed of aluminium or an alloy thereof and has a copper coating, and/or that the carrier plate (24) of the second printed circuit board (2b) is free at one end from the insulation layer (8) and/or that the free end (4b) of the carrier plate (24) of the second printed circuit board (2b) forms an electrical connecting point.

14. Circuit according to Claim 5, **characterised in that** the printed circuit boards (2a, b) are mechanically connected to one another by means of at least one semiconductor and/or the outer edge of a first printed circuit board (2a) comprising the connecting region (10a-10d) runs parallel to an outer edge of a second printed circuit board (2b) accommodating the contact region and/or that the contact region and/or the contact pad (20) is arranged on the outer edge of the second printed circuit board (2b) facing towards the first printed circuit board (2a) and/or that the connecting region and/or the metallic coating (12) is arranged on the outer edge of the first printed circuit board (2a) facing towards the second printed circuit board (2b) and/or that the contact region and/or the contact pad (20) of the second printed circuit board (2b) and the connecting region (10a-10d) and/or the metallic coating (12) of the first printed circuit board (2a) are facing towards one another and/or that the first printed circuit board (2a) and the second printed circuit board (2b) are mounted with at least a same semiconductor.

15. Method for producing a circuit according to Claim 5, **characterised in that** the distance between the printed circuit boards (2a, b) is bridged by a mounting with at least one semiconductor.

16. Method according to Claim 15, **characterised in that** the first printed circuit board (2a) according to Claim 1 and the second printed circuit board (2b) according to Claim 5 are provided on a common parts carrier of a mounting device.

17. Method according to Claim 16, **characterised in that** a first printed circuit board (2a) according to Claim 1 and a second printed circuit board (2b) according to Claim 5 are first of all formed on a monolithic carrier plate (14), and that the two printed circuit boards are formed separately before or after the mounting of the carrier plate (14).

18. Method according to Claim 17, **characterised in that** the printed circuit boards (2a, b) are connected to one another by connecting webs of the carrier plate (14).

## Revendications

1. Plaquette de circuit imprimé (2a), avec
- une plaque de support métallique (14),
- une couche isolante (8), qui isole électriquement la plaque de support métallique (14) sur une surface, la plaque de support (14) étant exempte de couche isolante (8) dans au moins une zone de connexion (10a - 10d), sachant que
- la plaque de support (14) est pourvue d'un revêtement métallique dans la zone de connexion (10a - 10d),
- sachant que, sur le revêtement métallique (12) de la zone de connexion (10a - 10d), un contact d'un élément semi-conducteur est en contact électrique,
**caractérisée en ce que** les zones non conductrices de l'élément semi-conducteur portent contre la couche isolante (8)

2. Plaquette de circuit imprimé (2a) selon la revendication 1,
**caractérisée en ce que** la couche isolante (8) est une laque d'arrêt de brasage et / ou que la couche isolante (8) est apposée sur la plaque de support (14) .

3. Plaquette de circuit imprimé (2a) selon l'une des revendications précédentes,
**caractérisée en ce que** le revêtement métallique (12) est une couche d'étain et / ou que le revêtement métallique (12) est sensiblement à surface plane parallèle par rapport à la surface de la couche isolante (8) .

4. Plaquette de circuit imprimé (2a) selon l'une des revendications précédentes
**caractérisée en ce que** le contact est mis en contact électrique avec la plaque de support (14) par l'intermédiaire du revêtement métallique (12) et que la plaque de support (14) est dotée d'une extrémité libre (4a) pour la mise en contact du contact avec un circuit électrique.

5. Circuit imprimé dote d'une première plaquette de circuit imprimé (2a) selon la revendication 1 et d'une deuxième plaquette de circuit imprimé (2b), avec
- une plaque de support métallique (14),
- un isolateur (16) pour l'isolation électrique de la plaque de support métallique (14) sur une surface,
- une couche conductrice, appliquée sur l'isolateur (16), **caractérisé en ce que**
- l'isolateur (16), ainsi que la couche conductrice sont ajourés dans au moins une zone de contact, et
- que, dans la zone de contact, au moins un plot de contact métallique (20) est disposé sur la plaque de support (14) de manière à ce que le plot de contact (20) soit distancé périphériquement de l'isolateur (16) et de la couche conductrice et
- que la première plaquette de circuit imprimé (2a) est distancée de la deuxième plaquette de circuit imprimé (2b) au moyen d'un entrefer ou d'un matériau isolant.

6. Circuit imprimé selon la revendication 5,
**caractérisé en ce que** le plot de contact (20) de la deuxième plaquette de circuit imprimé (2b) est sensiblement à surface plane parallèle par rapport à la couche conductrice de la deuxième plaquette de circuit imprimé (2b) et / ou que le plot de contact (20) de la deuxième plaquette de circuit imprimé (2b) est disposé dans une section exposée de la zone de contact de la deuxième plaquette de circuit imprimé (2b).

7. Circuit imprimé selon revendication 5 ou 6,
**caractérisé en ce que** la zone de contact de la deuxième plaquette de circuit imprimé (2b) est conçue pour la réception d'au moins deux plots de contact (20) et que la zone de contact de la deuxième plaquette de circuit imprimé (2b) est exempte d'isolateur (16) et / ou qu'un espace annulaire est agencé entre le plot de contact (20) de la deuxième plaquette de circuit imprimé (2b) et la couche conductrice de la deuxième plaquette de circuit imprimé (2b) et / ou la couche isolante (8) de la deuxième plaquette de circuit imprimé (2b), en particulier que la distance entre le plot de contact (20) de la deuxième plaquette de circuit imprimé (2b) et la couche conductrice de la deuxième plaquette de circuit imprimé (2b) est inférieure à 1 mm, en particulier inférieure à 0,5 mm, de préférence inférieure à 0,1 mm.

8. Circuit imprimé selon l'une des revendications 5 à 7,
**caractérisé en ce que** l'espace, existant entre le plot de contact (20) de la deuxième plaquette de circuit imprimé (2b) et la couche conductrice de la deuxième plaquette de circuit imprimé (2b) et / ou l'isolateur (16) de la deuxième plaquette de circuit imprimé (2b) est exempt de matière de remplissage et / revêtu d'une couche isolante (8).

9. Circuit imprimé selon l'une des revendications 5 à 8,
**caractérisé en ceque** au moins un plot de connexion (22) de la deuxième plaquette de circuit imprimé (2b) est relié électriquement à la couche conductrice de la deuxième plaquette de circuit imprimé (2b) et / ou que le plot de contact (20) de la deuxième plaquette de circuit imprimé (2b) est mis en contact électrique avec un contact source ou drain d'un semi-conducteur de puissance et que le plot de connexion (22) de la deuxième plaquette de circuit imprimé (2b) est mis en contact électrique avec un contact Gate du semi-conducteur de puissance.

10. Circuit imprimé selon la revendication 9,
**caractérisé en ce que** le contact source ou drain est mis en contact électrique avec la plaque de support (24) de la deuxième plaquette de circuit imprimé (2b) par l'intermédiaire du plot de contact (20) de la deuxième plaquette de circuit imprimé (2b) et / ou que la plaque de support (24) de la deuxième plaquette de circuit imprimé (2b) est dotée d'une extrémité libre (4b) pour la mise en contact du contact source ou drain avec un circuit électrique, et / ou que le contact Gate est en contact électrique avec la couche conductrice de la deuxième plaquette de circuit imprimé (2b) et que, sur la couche conductrice de la deuxième plaquette de circuit imprimé (2b), sont formées des pistes conductrices (18) pour un circuit de commande du contact Gate.

11. Circuit imprimé selon l'une des revendications 5 ou 10,
**caractérisé en ce qu'**au moins un plot de connexion (22) de la deuxième plaquette de circuit imprimé (2b) et / ou au moins un plot de contact (20) de la deuxième plaquette de circuit imprimé (2b) sont disposés dans le secteur d'un bord de la deuxième plaquette de circuit imprimé (2b) et / ou que la zone de contact de la deuxième plaquette de circuit imprimé (2b) est disposée le long d'un bord longitudinal (24a) de la deuxième plaquette de circuit imprimé (2b).

12. Circuit imprimé selon l'une des revendications 5 à 11,
**caractérisé en ce que** le plot de connexion (22) de la deuxième plaquette de circuit imprimé (2b) et le plot de contact (20) de la deuxième plaquette de circuit imprimé (2b) sont disposés sensiblement à surface plane parallèle l'un par rapport à l'autre.

13. Circuit imprimé selon l'une des revendications précédentes,
**caractérisé en ce que** la plaque de support (24) de la deuxième plaquette de circuit imprimé (2b) est dotée d'une épaisseur d'au moins 1 mm, de préférence d'au moins 1,5 mm, mais inférieure à 50 mm et / ou que la plaque de support (24) de la deuxième plaquette de circuit imprimé (2b) est réalisée en cuivre ou en un alliage de celui-ci ou que la plaque de support (24) de la deuxième plaquette de circuit imprimé (2b) est réalisée en aluminium ou en un alliage de celui-ci et est dotée d'un revêtement de cuivre et / ou que la plaque de support (24) de la deuxième plaquette de circuit imprimé (2b) est, à une extrémité, exempte de la couche isolante (8) et / ou que l'extrémité libre (4b) de la plaque de support (24) de la deuxième plaquette de circuit imprimé (2b) forme un point de connexion électrique.

14. Circuit imprimé selon la revendication 5,
**caractérisé en ce que** les plaquettes de circuit imprimé (2a,b) sont reliées ensemble mécaniquement par au moins un semi-conducteur et / ou que le bord extérieur d'une première plaquette de circuit imprimé (2a), qui est doté de la zone de connexion (10a - 10d), s'étend parallèlement à un bord extérieur d'une deuxième plaquette de circuit imprimé (2b), qui reçoit la zone de contact, et / ou que la zone de contact et / ou le plot de contact (20) sont disposés sur le bord extérieur de la deuxième plaquette de circuit imprimé (2b), qui est orienté vers la première plaquette de circuit imprimé (2a) et / ou que la zone de connexion et / ou le revêtement métallique (12) sont disposés sur le bord extérieur de la première plaquette de circuit imprimé (2a) orienté vers la deuxième plaquette de circuit imprimé (2b) et / ou que la zone contact et / ou le plot de contact (20) de la deuxième plaquette de circuit imprimé (2b) et la zone de connexion (10a - 10d) et / ou le revêtement métallique (12) de la première plaquette de circuit imprimé (2a) sont orientés les uns vers les autres, et / ou que la première plaquette de circuit imprimé (2a) et la deuxième plaquette de circuit imprimé (2b) sont équipées en commun avec au moins un même semi-conducteur.

15. Procédé de fabrication d'un circuit imprimé selon la revendication 5,
**caractérisé en ce que** pour ponter l'intervalle entre les plaquette de circuit imprimé (2a,b), est réalisé un équipement comprenant au moins un semi-conducteur.

16. Procédé selon la revendication 15,
**caractérisé en ce que** la première plaquette de circuit imprimé (2a) selon la revendication 1 et la deuxième plaquette de circuit imprimé (2b) selon a revendication 5 sont conduites à un dispositif d'équipement sur un support commun.

17. Procédé selon la revendication 16,
**caractérisé en ce qu'**une première plaquette de circuit imprimé (2a) selon la revendication 1 et une deuxième plaquette de circuit imprimé (2b) selon la revendication 5 sont d'abord formées sur une plaque de support (14) monolithique, **que** las deux plaquette de circuit imprimé (2a, b) sont séparées avant ou après l'équipement de la plaque de support (14).

18. Procédé selon la revendication 17,
**caractérisé en ce que** les plaquettes de circuit imprimé (2a, b) sont reliées ensemble par des pattes de liaison de la plaque de support (14)
